# EUROPEAN PATENT APPLICATION

(11) **EP 4 494 923 A1**
(43) Date of publication of application: **22.01.2025**
(21) Application number: 24184603.9
(22) Date of filing: 26.06.2024
(51) Int. Cl.: B60L 53/62, B60L 58/24, H01M 10/44, H01M 10/48

(54) **DETERMINING THERMAL RUNAWAY IN AN ELECTRIC VEHICLE BATTERY**

(30) Priority: 20.07.2023 US 202318224285
(71) Applicant: Honeywell International Inc., Charlotte, NC 28202 (US)
(72) Inventor: GOMEZ LUIS, Alexia Itzel, Charlotte, 28202 (US); AYALA RUIZ, Daniel, Charlotte, 28202 (US)
(74) Representative: Haseltine Lake Kempner LLP

(57) **Abstract**

Devices, methods, and systems for determining thermal runaway in an electric vehicle battery are described herein. One device includes a thermal camera configured to determine a change in temperature of a battery of an electric vehicle as the battery is being charged by an electric vehicle charging station, and determine, based on the change in the temperature of the battery as the battery is being charged, whether thermal runaway will occur in the battery. An indication can be provided upon the thermal camera determining thermal runaway will occur in the battery.

## Description

### Technical Field

The present disclosure relates generally to devices, methods, and systems for determining thermal runaway in an electric vehicle battery.

### Background

An electric vehicle is a vehicle that uses an electric motor for propulsion. For instance, an electric vehicle may use an electric motor instead of, or in combination with, a gasoline-powered engine. Examples of electric vehicles include electric automobiles (e.g., cars), electric trucks, electric buses, electric motorcycles, electric bicycles, electric drones, or any other type of electric vehicle used to transport people and/or goods.

Electric vehicles can provide a number of environmental benefits. For example, electric vehicles can operate more efficiently than gasoline-powered vehicles, and/or can have fewer emissions than gasoline-powered vehicles.

An electric vehicle may include a rechargeable battery, usually a lithium (e.g., lithium-ion) battery, that is used to power the electric motor of the electric vehicle. The battery of an electric vehicle can be charged using (e.g. by connecting the battery to) an electric vehicle charging station, which can supply electrical power to charge the battery.

### Brief Description of the Drawings

Figure 1 illustrates a system for determining thermal runaway in an electric vehicle battery in accordance with an embodiment of the present disclosure.
Figure 2 illustrates a block diagram of an electric vehicle charging station in accordance with an embodiment of the present disclosure.
Figure 3 is a graph illustrating an example of thermal change leading to thermal runaway occurring in a battery of an electric vehicle.

### Detailed Description

Devices, methods, and systems for determining thermal runaway in an electric vehicle battery are described herein. One device includes a thermal camera configured to determine a change in temperature of a battery of an electric vehicle as the battery is being charged by an electric vehicle charging station, and determine, based on the change in the temperature of the battery as the battery is being charged, whether a critical temperature change that could drive a thermal runaway is occurring in the battery. An indication can be provided upon the thermal camera determining thermal runaway will occur in the battery.

In some instances, the battery of an electric vehicle may be susceptible to thermal runaway. For example, thermal runaway may occur in the battery of an electric vehicle while the battery is being charged by an electric vehicle charging station, which can cause damage to the battery and/or cause the battery to light on fire and/or explode. Accordingly, the occurrence of thermal runaway in the battery, which will be further described herein, can be an unsafe, dangerous condition.

Previous approaches of monitoring for thermal runaway in electric vehicle batteries, however, may not be able to detect thermal runaway until it is actually occurring (e.g., has begun to occur), or has already occurred. Accordingly, such previous approaches may not be able to prevent thermal runaway from occurring while the battery is being charged, and therefore may not be able to prevent damage to the battery and/or prevent the battery from lighting on fire and/or exploding.

Embodiments of the present disclosure, however, can determine (e.g., predict) whether thermal runaway will occur in a charging electric vehicle battery before it actually begins to occur. For instance, embodiments of the present disclosure can determine whether thermal runaway will occur based on a change in temperature of the battery as the battery is being charged. Accordingly, embodiments of the present disclosure can prevent thermal runaway from occurring while the battery is being charged, and therefore can prevent damage to the battery and prevent the battery from lighting on fire and/or exploding.

In the following detailed description, reference is made to the accompanying drawings that form a part hereof. The drawings show by way of illustration how one or more embodiments of the disclosure may be practiced.

These embodiments are described in sufficient detail to enable those of ordinary skill in the art to practice one or more embodiments of this disclosure. It is to be understood that other embodiments may be utilized and that mechanical, electrical, and/or process changes may be made without departing from the scope of the present disclosure.

As will be appreciated, elements shown in the various embodiments herein can be added, exchanged, combined, and/or eliminated so as to provide a number of additional embodiments of the present disclosure. The proportion and the relative scale of the elements provided in the figures are intended to illustrate the embodiments of the present disclosure and should not be taken in a limiting sense.

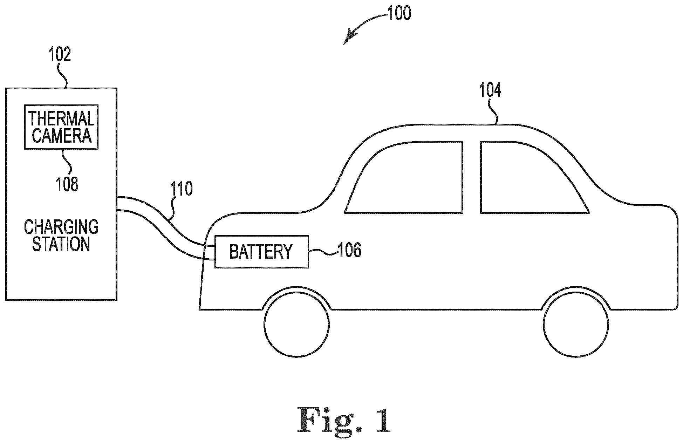

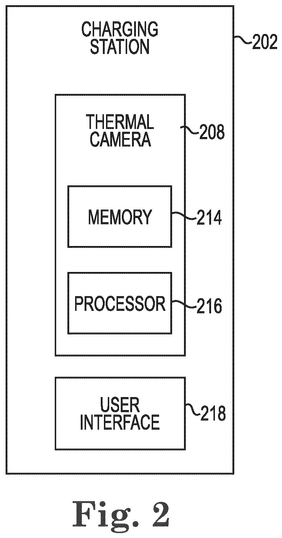

The figures herein follow a numbering convention in which the first digit or digits correspond to the drawing figure number and the remaining digits identify an element or component in the drawing. Similar elements or components between different figures may be identified by the use of similar digits. For example, 102 may reference element "02" in Figure 1, and a similar element may be referenced as 202 in Figure 2.

As used herein, "a", "an", or "a number of" something can refer to one or more such things, while "a plurality of" something can refer to more than one such things. For example, "a number of components" can refer to one or more components, while "a plurality of components" can refer to more than one component.

Figure 1 illustrates a system 100 for determining thermal runaway in an electric vehicle (e.g., vehicle 104) battery in accordance with an embodiment of the present disclosure. In the example illustrated in Figure 1, electric vehicle 104 is an electric automobile (e.g., car). However, embodiments of the present disclosure are not so limited. For example, electric vehicle 104 can be an electric truck, electric bus, electric motorcycle, electric bicycle, electric drone, or any other type of electric vehicle used to transport people and/or goods. Although not shown in Figure 1 for simplicity and so as to not obscure embodiments of the present disclosure, electric vehicle 104 can include (e.g., use) an electric motor (e.g., in combination with, or instead of, a gasoline-powered engine) for propulsion.

As shown in Figure 1, electric vehicle 104 can include a rechargeable battery 106. Battery 106 can be used to power the electric motor of electric vehicle 104. Battery 106 can be, for example, a lithium (e.g. lithium-ion) battery.

As shown in Figure 1, system 100 can include an electric vehicle charging station 102. Charging station 102 can be used to charge battery 106 of electric vehicle 104. For instance, as illustrated in Figure 1, battery 106 can be connected to charging station 102 via connector 110 (e.g., by plugging connector 110 into battery 106), and charging station 102 can supply electrical power to battery 106 via connector 110 to charge battery 106. Charging station 102 can be, for instance, an alternating current (AC) or direct current (DC) charging station. Connector 110 can be any type of connector that is compatible with (e.g., capable of being plugged into and supplying power to) battery 106.

As shown in Figure 1, charging station 102 includes a thermal camera 108. Thermal camera 108 can determine (e.g., sense and/or measure) a change in temperature of battery 106 as it is being charged by charging station 102. For example, thermal camera 108 can determine the change in the temperature of battery 106 by capturing a thermal image (e.g., heat signature) of battery 106 as it is being charged by charging station 102.

Thermal camera 108 can determine (e.g., predict), based on the change in the temperature of battery 106 as it is being charged, whether thermal runaway will occur (e.g., before it actually begins to occur). For instance, thermal camera 108 can determine whether thermal runaway will occur in battery 106 using a Kalman filter algorithm, as will be further described herein.

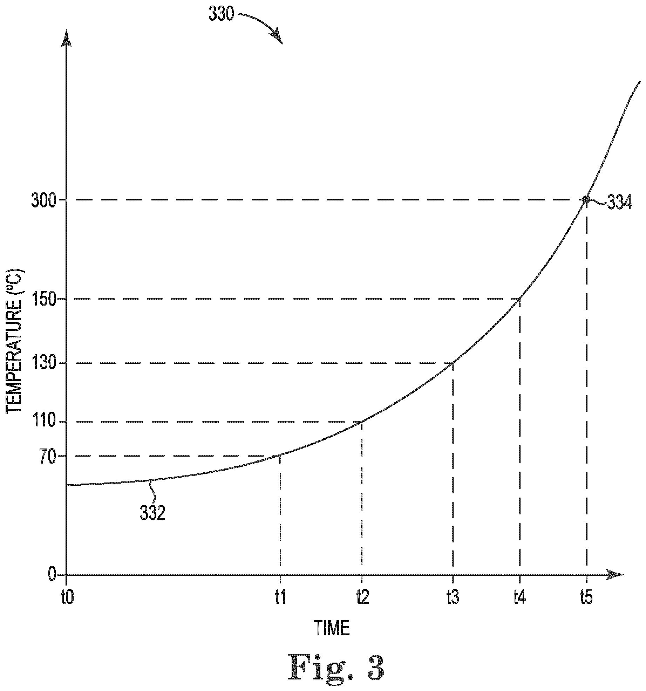

As used herein, thermal runaway can include and/or refer to a process in which an increasing temperature causes an energy release, which in turn further increases the temperature, which further accelerates the release of energy. For example, thermal runaway may occur in battery 106 when the temperature of battery 106 increases to (e.g., reaches) a point that changes the conditions of (e.g., causes chemical reactions in) battery 106, causing further chemical reactions that produce more heat. This process can continue (e.g., accelerate) until the battery is damaged, lights on fire, and/or explodes. An example illustrating thermal runaway occurring in a battery (e.g., battery 106) will be further described herein (e.g., in connection with Figure 3).

As an example, a temperature gradient associated with thermal runaway of a battery of an electric vehicle (e.g., battery 106 of electric vehicle 104) can be defined and stored in a processor of thermal camera 108 after modeling the thermal runaway. The temperature gradient can be, for example, an amount of (e.g., how much) temperature variation in the battery over a period of time that would be expected to cause (e.g., lead to) thermal runaway to occur in the battery. The temperature gradient can be a pre-defined temperature gradient. For instance, the temperature gradient can be defined before charging station 102 is used to charge a battery of an electric vehicle (e.g., during manufacture of charging station 102).

As battery 106 is being charged, a model of the change in the temperature of battery 106 can be generated by thermal camera 108 data. Then, using a Kalman filter algorithm (e.g., by inputting the temperature change determined by thermal camera 108 into a Kalman filter algorithm), the temperature gradient of the thermal runaway can be defined.

Thermal camera 108 can determine whether thermal runaway will occur in battery 106 based on the model of the change in the temperature of battery 106. For example, thermal camera 108 can compare the change in the temperature of battery 106 (e.g., the model of the change in temperature of the battery) to the temperature gradient, and determine whether thermal runaway will occur in battery 106 based on the comparison. For instance, thermal camera 108 can determine, based on the comparison, whether the change in the temperature of battery 106 as it is being charged is outside of (e.g. not within) the temperature gradient (e.g., whether the temperature of the battery is varying too much over too short a period of time), and determine whether thermal runaway will occur in battery 106 based on whether the change in the temperature of battery 106 as it is being charged is outside of the temperature gradient. If the comparison indicates the change in the temperature of battery 106 as it is being charged (e.g., the model of the change in temperature) is outside of the temperature gradient, thermal camera 108 can determine thermal runaway will occur in battery 106. If the comparison indicates the change in the temperature of battery 106 as it is being charged (e.g., the model of the change in temperature) is not outside of (e.g., is within) the temperature gradient, thermal camera 108 can determine thermal runaway will not occur in battery 106.

Upon thermal camera 108 determining thermal runaway will occur in battery 106, charging station 102 can provide an indication that thermal runaway will occur. As an example, charging station 102 can display the indication on a user interface of charging station 102. As an additional example, charging station 102 can provide the indication by generating an alarm upon determining thermal runaway will occur. The alarm can be, for instance, an audio (e.g., voice) alarm emitted by charging station 102, or a visual alarm (e.g., an illumination of a warning light on charging station 102). As an additional example, charging station 102 can shut off (e.g., cease providing electrical power to battery 106) upon determining thermal runaway will occur in battery 106. As such, charging station 102 can provide the indication, and/or shut off, before thermal runaway has occurred (e.g., has begun to occur) in battery 106.

In some embodiments, charging station 102 can, during its operation (e.g., charging batteries of electric vehicles) use machine learning to determine (e.g., learn) what temperature changes in the batteries cause thermal runaway, and what temperature changes in the batteries do not cause thermal runaway, and adjust (e.g., update) the temperature gradient accordingly. For example, charging station 102 can adjust the temperature gradient based on whether the change in temperature of battery 106 determined by thermal camera 108 has caused thermal runaway to occur. For instance, if the change in temperature of battery 106 caused thermal runaway to occur, charging station 102 can adjust the temperature gradient to include that temperature change. If the change in temperature of battery 106 did not cause thermal runaway to occur, charging station 102 can adjust the temperature gradient to not include that temperature change.

Charging station 102 can utilize the adjusted (e.g., updated) temperature gradient to determine whether thermal runaway will occur in batteries subsequently charged by charging station 102. For example, thermal camera 108 can determine a change in temperature of the battery of an additional electric vehicle (e.g., an electric vehicle whose battery is being charged by charging station 102 after battery 106 of electric vehicle 104 has been charged) as it is being charged by charging station 102, in a manner analogous to that previously described for battery 106. The Kalman filter in thermal camera 108 can generate a model of the change in the temperature of the battery of the additional electric vehicle, in a manner analogous to that previously described for battery 106. Thermal camera 108 can compare the change in the temperature of the battery of the additional electric vehicle (e.g., the model of the change in temperature of the battery) to the adjusted temperature gradient, and determine whether thermal runaway will occur in the battery of the additional electric vehicle based on the comparison to the adjusted temperature gradient, in a manner analogous to that previously described for battery 106. Upon determining thermal runaway will occur in the battery of the additional electric vehicle, charging station 102 can provide an indication that thermal runaway will occur and/or shut off, in a manner analogous to that previously described for battery 106.

Figure 2 illustrates a block diagram of an electric vehicle charging station 202 in accordance with an embodiment of the present disclosure. Charging station 202 can be, for example, electric vehicle charging station 102 previously described in connection with Figure 1. For example, charging station 202 can include thermal camera 208, which can be analogous to thermal camera 108 previously described in connection with Figure 1. Thermal camera 208 can determine (e.g., predict) whether thermal runaway will occur in the battery of an electric vehicle being charged by charging station 202 based on the change in the temperature of the battery as it is being charged, as previously described herein.

As shown in Figure 2, thermal camera 208 can include a memory 214 and a processor 216. The memory 214 can be any type of storage medium that can be accessed by the processor 216 to perform various examples of the present disclosure. For example, the memory 214 can be a non-transitory computer readable medium having computer readable instructions (e.g., computer program instructions) stored thereon that are executable by the processor 216 for determining thermal runaway in accordance with the present disclosure. Further, memory 214 can store a temperature gradient associated with thermal runaway of a battery of an electric vehicle, which can be used to determine thermal runaway, as previously described herein.

The memory 214 can be volatile or nonvolatile memory. The memory 214 can also be removable (e.g., portable) memory, or non-removable (e.g., internal) memory. For example, the memory 214 can be random access memory (RAM) (e.g., dynamic random access memory (DRAM) and/or phase change random access memory (PCRAM)), read-only memory (ROM) (e.g., electrically erasable programmable read-only memory (EEPROM) and/or compact-disc read-only memory (CD-ROM)), flash memory, a laser disc, a digital versatile disc (DVD) or other optical storage, and/or a magnetic medium such as magnetic cassettes, tapes, or disks, among other types of memory.

Further, although memory 214 is illustrated as being located within thermal camera 208, embodiments of the present disclosure are not so limited. For example, memory 214 can also be located internal to another computing resource (e.g., the thermal camera processor 216).

As shown in Figure 2, charging station 202 can include a user interface 218. A user (e.g., operator) of charging station 202 can interact with charging station 202 via the user interface 218. For example, the user interface 218 can provide (e.g., display and/or present) information to the user of charging station 202, and/or receive information from (e.g., input by) the user of charging station 202. For instance, in some embodiments, user interface 218 can be a graphical user interface (GUI) that can provide and/or receive information to and/or from the user of charging station 202, such as, for example, an indication that thermal runaway will occur in a battery of an electric vehicle being charged by charging station 202, as previously described herein. The display can be, for instance, a touch-screen (e.g., the GUI can include touch-screen capabilities). Alternatively, a display can include a television, computer monitor, mobile device screen, other type of display device, or any combination thereof, connected to charging station 202 and configured to receive a video signal output from charging station 202.

The user interface 218 can be localized to any language. For example, the user interface 218 can display information in any language, such as English, Spanish, German, French, Mandarin, Arabic, Japanese, Hindi, etc.

Figure 3 is a graph 330 illustrating an example of thermal change leading to thermal runaway occurring in a battery of an electric vehicle. The battery can be, for instance, battery 106 of electric vehicle 104 previously described in connection with Figure 1. For instance, the battery can be a lithium (e.g. lithium-ion) battery.

As shown in Figure 3, graph 330 includes temperature curve 332. Temperature curve 332 represents the temperature (e.g., the change in the temperature) of the battery over time as the battery is being charged (e.g., by an electric vehicle charging station, such as, for instance, electric vehicle charging station 102 previously described in connection with Figure 1).

For example, the battery begins to be charged at time t0 illustrated in Figure 3. At time t1 illustrated in Figure 3, the temperature of the battery has increased to (e.g., reaches) 70 degrees Celsius, as shown in Figure 3. At this point, the solid electrolyte interface (SEI) of the battery may begin to decompose, and the rate at which the temperature of the battery increases may begin to accelerate as the battery continues to be charged, as illustrated in Figure 3.

At time t2 illustrated in Figure 3, the temperature of the battery has increased to 110 degrees Celsius, as shown in Figure 3. At this point, the electrolyte solvent of the battery may begin to react with the negative electrode (e.g., anode) of the battery, and the rate at which the temperature of the battery increases may further accelerate as the battery continues to be charged, as illustrated in Figure 3.

At time t3 illustrated in Figure 3, the temperature of the battery has increased to 130 degrees Celsius, as shown in Figure 3. At this point, the separator of the battery (e.g., the mechanism that prevents the positive electrode and negative electrode of the battery from shorting) may begin to melt, and the rate at which the temperature of the battery increases may further accelerate as the battery continues to be charged, as illustrated in Figure 3.

At time t4 illustrated in Figure 3, the temperature of the battery has increased to 150 degrees Celsius, as shown in Figure 3. At this point, the electrolyte solvent of the battery may begin to decompose, and the rate at which the temperature of the battery increases may further accelerate as the battery continues to be charged, as illustrated in Figure 3.

At time t5 illustrated in Figure 3, the temperature of the battery has increased to 300 degrees, as shown in Figure 3. At this point, the electrolyte solvent of the battery may begin to react with the positive electrode (e.g., cathode) of the battery, and thermal runaway will have occurred. That is, point 334 on temperature curve 330 is the point at which thermal runaway starts after the temperature change window from t0 to t5 illustrated in Figure 3.

Embodiments of the present disclosure, however, can prevent the thermal runaway illustrated in Figure 3 from occurring. For example, embodiments of the present disclosure can determine (e.g., predict) whether thermal runaway will occur in a charging electric vehicle battery before it actually begins to occur, as previously described herein.

Although specific embodiments have been illustrated and described herein, those of ordinary skill in the art will appreciate that any arrangement calculated to achieve the same techniques can be substituted for the specific embodiments shown. This disclosure is intended to cover any and all adaptations or variations of various embodiments of the disclosure.

It is to be understood that the above description has been made in an illustrative fashion, and not a restrictive one. Combination of the above embodiments, and other embodiments not specifically described herein will be apparent to those of skill in the art upon reviewing the above description.

The scope of the various embodiments of the disclosure includes any other applications in which the above structures and methods are used. Therefore, the scope of various embodiments of the disclosure should be determined with reference to the appended claims, along with the full range of equivalents to which such claims are entitled.

In the foregoing Detailed Description, various features are grouped together in example embodiments illustrated in the figures for the purpose of streamlining the disclosure. This method of disclosure is not to be interpreted as reflecting an intention that the embodiments of the disclosure require more features than are expressly recited in each claim.

Rather, as the following claims reflect, inventive subject matter lies in less than all features of a single disclosed embodiment. Thus, the following claims are hereby incorporated into the Detailed Description, with each claim standing on its own as a separate embodiment.

## Claims

1. An electric vehicle charging station (102, 202), comprising:
a thermal camera (108, 208) configured to:
determine a change in temperature of a battery (106) of an electric vehicle (104) as the battery (106) is being charged by the electric vehicle charging station (102, 202); and
determine, based on the change in the temperature of the battery (106) as the battery (106) is being charged, whether thermal runaway will occur in the battery (106); and
wherein the electric vehicle charging station (102, 202) is configured to provide an indication upon the thermal camera (108, 208) determining thermal runaway will occur in the battery (106).

2. The electric vehicle charging station of claim 1, wherein the thermal camera is configured to determine whether thermal runaway will occur in the battery by:
generating a model of the change in the temperature of the battery as the battery is being charged; and
comparing the model of the change in the temperature of the battery as the battery is being charged to a temperature gradient associated with thermal runaway of a battery of an electric vehicle.

3. The electric vehicle charging station of claim 2, wherein the temperature gradient is a pre-defined temperature gradient.

4. The electric vehicle charging station of claim 2, wherein the temperature gradient is an adjusted temperature gradient.

5. The electric vehicle charging station of claim 2, wherein the thermal camera is configured to determine thermal runaway will occur in the battery upon the comparison indicating the model of the change in the temperature of the battery as the battery is being charged is outside the temperature gradient.

6. The electric vehicle charging station of claim 2, wherein the thermal camera is configured to determine thermal runaway will not occur in the battery upon the comparison indicating the model of the change in the temperature of the battery as the battery is being charged is not outside of the temperature gradient.

7. The electric vehicle charging station of claim 1, wherein the thermal camera is configured to determine whether thermal runaway will occur in the battery using a Kalman filter algorithm.

8. The electric vehicle charging station of claim 1, wherein the thermal camera is configured to determine the change in the temperature of the battery by capturing a thermal image of the battery as the battery is being charged by the electric vehicle charging station.

9. A method of operating an electric vehicle charging station (102, 202), comprising:
determining a change in temperature of a battery (106) of an electric vehicle (104) as the battery (106) is being charged by the electric vehicle charging station (102, 202);
generating a model of the change in the temperature of the battery (106) as the battery (106) is being charged;
determining, based on the model of the change in the temperature of the battery (106) as the battery (106) is being charged, whether thermal runaway will occur in the battery (106); and
providing an indication upon determining thermal runaway will occur in the battery (106).

10. The method of claim 9, wherein the method includes determining the change in the temperature of the battery using a thermal camera (108, 208) of the electric vehicle charging station.

11. The method of claim 10, wherein the method includes generating the model of the change in the temperature of the battery using data of the thermal camera.

12. The method of claim 9, wherein the battery is a lithium battery.

13. The method of claim 9, wherein providing the indication comprises generating an alarm upon determining thermal runaway will occur in the battery.

14. The method of claim 9, wherein the method includes shutting off the electric vehicle charging station upon determining thermal runaway will occur in the battery.

15. The method of claim 9, wherein the method includes providing the indication before thermal runaway has occurred in the battery.
